Europäisches Patentamt

European Patent Office

Office européen des brevets

(19)

(11) Veröffentlichungsnummer: **0 189 179**
**B1**

(12) **EUROPÄISCHE PATENTSCHRIFT**

(45) Veröffentlichungstag der Patentschrift: **13.06.90**

(51) Int. Cl.⁵: **G 01 R 1/073**

(21) Anmeldenummer: **86100780.5**

(22) Anmeldetag: **22.01.86**

(54) **Prüfadapter.**

(30) Priorität: **22.01.85 DE 3501874**

(43) Veröffentlichungstag der Anmeldung:
**30.07.86 Patentblatt 86/31**

(45) Bekanntmachung des Hinweises auf die
Patenterteilung:
**13.06.90 Patentblatt 90/24**

(84) Benannte Vertragsstaaten:
**AT CH DE LI**

(56) Entgegenhaltungen:
**EP-A-0 026 824**
**DE-A-2 508 859**
**DE-A-3 115 787**
**DE-A-3 240 415**
**US-A-4 183 609**

(73) Patentinhaber: **Feinmetall Gesellschaft mit
beschränkter Haftung
Zeppelinstrasse 2
D-7033 Herrenberg (DE)**

(72) Erfinder: **Krüger, Gustav, Dr.
Danziger Strasse 1
D-7033 Herrenberg (DE)**

(74) Vertreter: **König, Oskar, Dr.-Ing. Dipl.-Phys.
Klüpfelstrasse 6 Postfach 10 27 33
D-7000 Stuttgart 1 (DE)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

**Beschreibung**

Die Erfindung betrifft einen Prüfadapter gemäß dem Oberbegriff des Anspruches 1.

Derartige Prüfadapter dienen in Verbindung mit einem an ihre Kontaktstifte angeschlossenen Auswerter dem elektrischen Prüfen von elektrischen, insbesondere elektronischen Prüflingen, wie elektrischen und elektronischen Bauteilen, Schaltungen, Schaltkreisen, Leiterplatten, integrierten Schaltungen, festen Verdrahtungen oder dergl., auf elektrische Fehlerfreiheit.

Bei einer einzelnen Prüfung dienen alle oder ausgewählte Kontaktstifte des Prüfadapters dem elektrischen Kontaktieren von Prüfstellen des Prüflinges. Der Kontaktstift bildet in seiner Gesamtheit einen "elektrischen Leiter" zum Leiten eines Prüfstromes bzw. einer Prüfspannung bei jeder Prüfung einer von ihm kontaktierten Prüfstelle eines Prüflinges.

Derartige Prüfadapter haben im allgemeinen eine sehr große Anzahl von Kontaktstiften, um eine große Anzahl von Prüfstellen eines Prüflinges gleichzeitig kontaktieren zu können. Oft wird, insbesondere bei sogenannten Universaladaptern, jeweils auch nur eine mehr oder weniger große Teilanzahl der im Prüfadapter befindlichen Kontaktstifte für die Prüfung von Prüfstellen des jeweiligen Prüflinges eingesetzt, indem nur sie an den Auswerter angeschlossen oder nur die von ihnen geleiteten Prüfströme bzw. -spannungen im Auswerter ausgewertet werden. Dabei handelt es sich jedoch stets auch um relativ große Anzahlen von Kontaktstiften, die an der Prüfung eines Prüflinges als "elektrische Leiter" mitwirken.

Infolge der zunehmenden Miniaturisierung bzw. zunehmender Funktionsvergrößerung von durch solche Prüfadapter zu prüfenden Prüflingen werden solche Prüfadapter mit immer mehr Kontaktstiften bestückt bzw. werden die Mittenabstände zwischen benachbarten Kontaktstiften oder das Rastermaß, falls die Kontaktstifte gemäß einem Raster gesteckt sind, immer kleiner.

Es gibt heute schon Prüfadapter, die mit mehr als 100 000 Kontaktstiften bestückt werden. Jeder Kontaktstift muß im Prüfadapter so gehalten sein, daß dieser sowohl alle vom Kontaktstift ausgeübten Kräfte als auch die vom Prüfling auf die Kontaktspitze des einzelnen Kontaktstiftes ausgeübte axiale Kontaktkraft aufnehmen kann. Bei großen Anzahlen von Kontaktstiften muß dann der Prüfadapter ohne Verlust an Prüfgenauigkeit sehr große Kräfte aushalten können. So kann die Kontaktkraft eines einzelnen Kontaktstiftes, mit der er an eine Prüfstelle eines Prüflinges angedrückt wird, im allgemeinen 0,3 bis 3N betragen. Auch das Eigengewicht der Kontaktstifte ist zu beachten. So können z.B. 100 000 Kontaktstifte zusammen beispielsweise 50 bis 100 kg wiegen. Die auf eine so große Anzahl von Kontaktstiften beim Prüfen eines Prüflinges ausgeübten axialen Kräfte können dabei bspw. 3 bis 30 t betragen. Die Außendurchmesser der Gehäuse der Kontaktstifte sind ferner wegen des notwendigen geringen Mittenabstandes zwischen benachbarten Kontaktstiften in ihrem Durchmesser sehr klein und liegen meist etwa zwischen 0,2 und 1,4 mm, besonders zweckmäßig etwa zwischen 0,4 und 0,8 mm.

Die Erfindung bezieht sich insbesondere auf Prüfadapter, die Kontaktstifte aufweisen, die in einer Frontgesamtplatte gehalten und/oder geführt sind und in deren Bereich vorzugsweise Durchmesser von maximal 1,4 mm, ggf. aber auch größere Durchmesser aufweisen können. Solche Kontaktstifte können Rückstellfedern aufweisen, insbesondere sogenannte Federkontaktstifte mit gesonderten Rückstellfedern sein, deren Gehäuse im Bereich der von ihnen durchdrungenen Frontgesamtplatte vorzugsweise Durchmesser von höchstens 1,4 mm aufweisen. Die Kontaktstifte können auch andere Bauarten aufweisen, bspw. als metallische Nadeln oder Drähte ausgebildet sein, die direkt in der Frontgesamtplatte geführt oder in in der Frontgesamtplatte angeordneten Führungshülsen geführt sind. Ggf. können auch noch in kleinerer Anzahl elektrisch leitende Sonderkontaktstifte vorhanden sein, die in manchen Fällen auch größere Außendurchmesser als 1,4 mm haben können, insbesondere sogenannte pneumatische Kontaktstifte. Solche Sonderkontaktstifte, deren Anzahl, falls überhaupt vorhanden, kleiner als die Anzahl der normalen Kontaktstifte ist, können am Prüfadapter auf gleiche oder auch andere Weise angeordnet werden, als im Oberbegriff des Anspruches 1 beschrieben. Bei Prüfadaptern, auf die sich die Erfindung bezieht, können zweckmäßig alle Kontaktstifte oder die überwiegende Anzahl der Kontaktstifte solche sein, wie sie im Oberbegriff des Anspruches 1 angesprochen sind.

Die Kontaktstifte bedürfen sehr genauer radialer Positionierung im Prüfadapter, und es ist sehr schwierig und teuer, in die solche Kontaktstifte positionierenden dicken Frontgesamtplatten der Prüfadapter die der Aufnahme der Kontaktstifte dienenden Durchgangsbohrungen wegen der geringen Durchmesser dieser Durchgangsbohrungen mit der erforderlichen Genauigkeit zu bohren, wenn die betreffende Platte oder Platten große Dicken haben müssen. Große Dicken solcher Frontgesamtplatten sind aber erforderlich, wenn sie sehr große Anzahlen, bspw. zehntausende oder hunderttausende solcher Kontaktstifte tragen und hierdurch große Kräfte aufnehmen müssen, damit sie die für eine Prüfung von Prüflingen erforderliche Starrheit im Betrieb haben.

Es ist zu diesem Zweck ein Prüfadapter bekannt (US—A—4,183,609), dessen Federkontaktstifte tragendes Gestell folgende Bauart hat: Es ist ein umlaufender dicker Rahmen vorhanden, auf dessen beiden zueinander parallelen Stirnseiten je eine relativ dünne Platte befestigt ist, die Durchgangsbohrungen aufweist, in die die noch leeren Gehäuse der Federkontaktstifte zu ihrer genauen Positionierung im Preßsitz eingesetzt werden. Danach werden die Positionierplatten auf ihren einander zugewendeten Innenseiten durch Aufgießen von je einer dickeren Kunstharzschicht zu einer Frontgesamtplatte und zu einer rückwärtigen Gesamtplatte, wobei diese dickeren Kunstharzschichten die Gehäuse der Federkontaktstifte festkleben, verdickt. Anschließend werden in die Gehäuse die die Kontaktspitzen tragenden Kolben und die sie belastenden Federn eingesetzt. Das spätere Auswechseln der die Kontaktspitzen tragenden Kolben und Federn ohne die Gehäuse ist dann zwar möglich, ergibt jedoch wegen der bis dahin unterschiedlichen Abnutzung der stehengebliebenen Gehäuse meist keine guten elektrischen Ergebnisse mehr. Darüber hinaus können bei diesem Prüfadapter die Gehäuse der Kontaktstifte wegen der dickeren angegossenen Kunstharzschichten nachträglich nicht mehr ohne weiteres ausgewechselt werden. Wenn also ein Gehäuse wegen Verschleißes oder Beschädigung unbrauchbar wird, kann es nicht herausgezogen und ausgewechselt werden. Zumindest sind seine nur unter Zerstörung mögliche Entfernung und das Einsetzen eines neuen Gehäuses mit sehr hohen Kosten verbunden, wenn dies überhaupt möglich ist.

Dagegen ist es bei solchen Prüfadaptern erwünscht, die Kontaktstifte trotz der großen Dicke zumindest der Frontgesamtplatte im Ganzen, d.h. als komplette Baueinheiten in die sie aufnehmende Platte oder Platten des Prüfadapters einzusetzen und sie jederzeit leicht und mit geringem Kostenaufwand im Ganzen auswechseln zu könn. Eine Möglichkeit hierfür wäre, die betreffende dicke Platte oder Platten des Prüfadapters mittels Bohrern mit Durchgangslöchern mit über ihre Länge konstanten Durchmessern zu versehen, die den Durchmessern der in sie einzusetzenden Kontaktstiftgehäuse ungefähr entsprechen, so daß man nachträglich die Kontaktstifte in diese Durchgangslöcher einsetzen und jederzeit wieder auswechseln kann. Dabei tritt jedoch das Problem auf, daß im Hinblick auf die geringen Durchmesser dieser Durchgangslöcher ihr Bohren bei dicken Platten sehr teuer ist wegen der Feinheit des Bohrers und auch die erforderliche Bohrgenauigkeit schwierig einzuhalten ist.

Es ist deshalb Aufgabe der Erfindung, einen Prüfadapter der im Oberbegriff des Anspruches 1 genannten Art zu schaffen, bei welchem die betreffenden Kontaktstifte jederzeit leicht ausgewechselt werden können und dennoch die Herstellung trotz der dicken Frontgesamtplatte kostengünstig möglich ist.

Diese Aufgabe wird erfindungsgemäß durch einen Prüfadapter gemäß Anspruch 1 gelöst.

Es ist zwar ein Prüfadapter bekannt (DE—A—32 40 415), der eine Positionsplatte aufweist, die auch aus mehreren Platten kompakt aufgebaut sein kann. Die Positionsplatte ist jedoch sehr dick, da in ihre jeweilige Durchgangsbohrung jeweils eine Feder und zwei durch diese Federn miteinander verbundene Federkontaktstifte eingesetzt sind. Diese Federkontaktstifte sind an ihr auch nicht axial abgestützt, sondern an einer sehr dicken Druckplatte, die für die Positionsplatte jedoch keine Stützplatte bildet, weil diese Positionsplatte keiner Stützung durch die Druckplatte bedarf.

Die Erfindung ermöglicht es, trotz der großen Dicke der Frontgesamtplatte ihre Durchgangslöcher für die Kontaktstifte kostengünstig und genau herzustellen. Die Kontaktstifte können leicht ausgewechselt werden, wobei dennoch die Kosten für die Herstellung dieser Durchgangsbohrungen nicht sehr hoch sind, weil jede Durchgangsbohrung der Frontgesamtplatte für einen solchen normalen Kontaktstift in zwei Längsabschnitte unterteilt ist, von denen nur der eine Abschnitt der genauen radialen und/oder axialen Positionierung des betreffenden Kontaktstiftes an der Frontgesamtplatte dient. Der restliche, im Durchmesser größere und auch längere Bereich dieser Durchgangsbohrung kann infolge des größeren Durchmessers kostengünstiger gebohrt werden. Der Kontaktstift berührt die Umfangswandung dieses restlichen Längsabschnittes der Durchgangsbohrung der Frontgesamtplatte nicht. Für diesen im Durchmesser größeren Längsabschnitt der Frontgesamtplatte kann also ein dickerer Bohrer mit entsprechend kostengünstigem Bohraufwand eingesetzt und auch weniger präzise gebohrt werden, wogegen der andere Längsabschnitt dieser Durchgangsbohrung wegen seiner Kürze und/oder wegen der möglichen Verringerung der Festigkeit des ihn aufweisenden Bereiches der Frontgesamtplatte kostengünstig genau hergestellt werden kann. Der Längsabschnitt des kleineren Durchmessers der Durchgangsbohrung kann besonders zweckmäßig viel kürzer als der restliche Längsabschnitt des größeren Durchmessers sein.

Bei erfindungsgemäßen Prüfadaptern können zweckmäßig die überwiegende Anzahl, also mehr als die halbe Anzahl der Kontaktstifte, vorzugsweise alle Kontaktstifte oder vorzugsweise alle Kontaktstifte, die keine Sonderkontaktstifte sind, besonders zweckmäßig zumindest alle nichtpneumatischen Kontaktstifte in Durchgangslöchern der Frontgesamtplatte gemäß Anspruch 1 angeordnet sein und besonders zweckmäßig im Bereich der Durchgangslöcher der Frontgesamtplatte Durchmesser von max. 1,4 mm aufweisen.

Die Frontgesamtplatte ist aus zwei gesonderten, aneinander anliegenden ebenen Scheiben gebildet, von denen die eine Scheibe als Positionierscheibe und die andere Scheibe als starre Stützplatte dient. Die Positionierscheibe kann dabei zweckmäßig die den Kontaktspitzen der Kontaktstifte benachbarte Scheibe und ferner vorzugsweise dünner, besonders zweckmäßig viel dünner als die Stützplatte sein und weist die Längsabschnitte der kleineren Durchmesser der Durchgangsbohrungen der Frontgesamtplatte auf.

Anstatt die Bohrungen der Positionierscheibe durch Bohren herzustellen können sie in manchen Fällen auch gestanzt oder auf sonstige Weise genau hergestellt werden.

In manchen Fällen ist es ausreichend, daß die betreffenden Kontaktstifte nur in der Frontgesamtplatte gehalten sind. Der Prüfadapter benötigt dann nicht unbedingt noch eine oder mehrere rückwärtige Platten, sondern die von den Kontaktstiften zum Auswerter führenden Leitungen können einfach an die Anschlußenden der Kontaktstifte angeschlossen, bspw. angelötet oder angeschweißt, werden. Da solche Kontaktstifte jedoch meist recht große Länge haben — deren Länge kann vorzugsweise wesentlich größer, insbesondere mehr- oder vielfach größer als die Dicke der Frontgesamtplatte sein — und sie sehr dünn sind, ist es besonders zweckmäßig, vorzusehen, daß der Prüfadapter im Abstand von der Frontgesamtplatte eine ebene, zu dieser Frontgesamtplatte vorzugsweise parallele, rückwärtige Gesamtplatte aufweist, die der rückwärtigen radialen Positionierung der Kontaktstifte und/oder deren Abstützung dienen und/oder dem elektrischen Anschluß der Kontaktstifte dienende Anschlußkontakte tragen kann.

Die rückwärtige Gesamtplatte kann aus einer einzigen einstückigen, vorzugsweise starren Platte bestehen oder wiederum aus zwei zueinander parallelen und aneinander anliegenden ebenen Scheiben zusammengesetzt sein. Im letzteren Falle kann dabei wiederum zweckmäßig eine dieser beiden Scheiben eine der Positionierung des Kontaktstiftes dienende Positionierscheibe und die andere Scheibe eine starre Stützplatte sein. Dabei kann die Stützplatte dann zweckmäßig dem elektrischen Anschluß der Kontaktstifte dienende Kontakte aufweisen. Dabei kann wiederum die Positionierscheibe, vorzugsweise dünner, insbesondere viel dünner als die Stützplatte sein.

Die Dicke der Positionierscheibe der Frontgesamtplatte bzw. der rückwärtigen Gesamtplatte kann zweckmäßig so klein wie möglich gemacht werden, vorzugsweise 0,1 bis 5 mm betragen. Die Positionierscheibe kann ggfs. sogar eine Folie oder ein Blatt sein, jedoch je nach Erfordernis auch größere Dicke bis zu 5 mm oder in Sonderfällen noch mehr aufweisen.

In der Zeichnung sind Ausführungsbeispiele der Erfindung dargestellt. Es zeigen:

Fig. 1 einen ausschnittsweisen Längsschnitt durch einen Prüfadapter gemäß einem Ausführungsbeispiel der Erfindung,

Fig. 2 einen vergrößerten, gebrochenen Ausschnitt aus Fig. 1,

Fig. 3 einen Prüfadapter in ausschnittsweiser, geschnittener Darstellung gemäß einem weiteren Ausführungsbeispiel der Erfindung, wobei von diesem Prüfadapter lediglich ein einziger Federkontaktstift dargestellt ist.

Die in der Zeichnung ausschnittsweise dargestellten Prüfadapter 10 bzw. 10' weisen außer den dargestellten, in allen Teilen metallischen Federkontaktstiften 11 bzw. 11' im allgemeinen noch eine sehr große Anzahl entsprechender Federkontaktstifte 11 bzw. 11' auf. Zusätzlich können sie noch außer diesen "normalen" Federkontaktstiften 11 bzw. 11' noch elektrisch leitfähige Sonderkontaktstifte, bspw. pneumatische, metallische Kontaktstifte, aufweisen, falls dies erwünscht oder notwendig ist, die auch anders ald die dargestellten "normalen" Kontaktstifte 11 bzw. 11' befestigt sein können. Alle Kontaktstifte 11 bzw. 11' bilden "elektrische Leiter", die im Prüfadapter 10 bzw. 10' gegeneinander elektrisch isoliert lösbar angeordnet sind, so daß jeder Federkontaktstift 11 bzw. 11' im ganzen auswechselbar ist.

Bei den dargestellten Prüfadaptern 10 bzw. 10' kann es sich vorzugsweise um sogenannte Universaladapter handeln, bei denen jeder einzelne Punkt eines einheitlichen Rasters mit einem Federkontaktstift 11 bzw. 11' besetzt ist, von denen beim Prüfen einer Sorte von Prüflingen nur jeweils die für die Prüfung auf deren Fehlerfreiheit benötigten Kontaktstifte vom Auswerter berücksichtigt werden. Die Erfindung ist jedoch auch bei anderen Prüfadaptern vorteilhaft anwendbar, deren Kontaktstifte jeweils entsprechend dem Muster der Prüfstellen nur einer Sorte von Prüflingen zugeordnet sind, so daß dann jeweils alle Kontaktstifte an der Prüfung dieser Prüflinge mitwirken. Auch andere Möglichkeiten bestehen.

In jedem Fall ist die Anzahl der Federkontaktstifte, wie 11 bzw. 11', pro Prüfadapter 10 bzw. 10' sehr groß und beträgt meist mindestens einige tausend, vorzugsweise einige zehntausend oder in manchen Fällen sogar mehr als hunderttausend Federkontaktstifte 11 bzw. 11'.

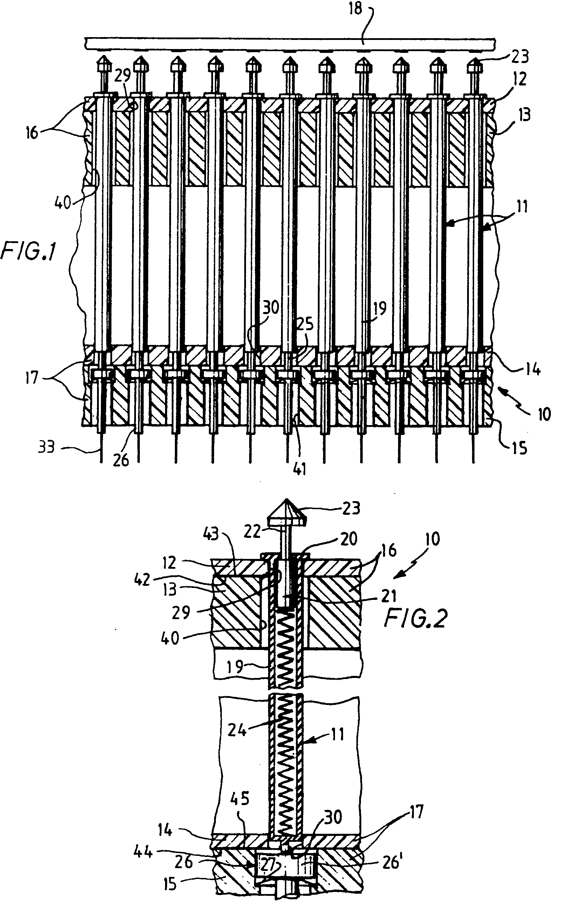

Der Prüfadapter 10 nach Fig. 1 und 2 weist einen nicht näher dargestellten Rahmen auf, an welchem insgesamt vier ebene, zueinander parallele Scheiben 12, 13, 14 und 15 befestigt sind, die paarweise zwei Gesamtplatten 16 bzw. 17 bilden, von denen jede aus den zwei aneinander anliegenden Einzelscheiben 12, 13 bzw. 14, 15 gebildet ist. Die einem jeweils zu prüfenden elektrischen oder elektronischen Prüfling, wie 18, bei dem es sich bspw. um eine Leiterplatte, um eine sonstige Schaltung oder dergl. handeln kann, benachbarte Gesamtplatte 16 sei als Frontgesamtplatte 16 bezeichnet und besteht aus der aus elektrisch isolierendem Kunststoff bestehenden Positionierscheibe 12 und der an deren Rückseite anliegenden und diese über ihre Breite und ihre Länge abstützenden Viel dickeren starren Stützplatte 13. Diese dicke Stützplatte 13 kann zweckmäßig aus hochfestem, starren Kunststoff oder auch aus anderen starren, hochfesten Materialien, wie Metall, Keramik oder dergl. bestehen. Falls sie aus Metall besteht, kann sie vorzugsweise einen elektrisch isolierenden Überzug aufweisen, bspw. zweckmäßig aus hartem Aluminium bestehen, das an der Oberfläche anodisch oxidiert ist.

Die beiden Scheiben 14, 15 der rückwärtigen Gesamtplatte 17 bestehen aus elektrisch isolierendem Kunststoff, von denen die dünnere eine Positionierscheibe 14 und die viel dickere eine starre Stützplatte 15 ist. Jeder metallische Federkontaktstift 11 (wie auch 11') bildet einen "elektrischen Leiter" geringen ohm'schen Durchgangswiderstandes. Der einzelne Federkontaktstift 11 besteht im Ausführungsbeispiel nach Fig. 1 und 2 aus einem dünnen, langen kreiszylindrischen metallischen Gehäuse 19, dessen obere Stirnseite mit einem Ringflansch oder Ringbund 20 auf der dem jeweiligen Prüfling 18 zugewendeten Außenoberfläche der oberen Positionierscheibe 12 zur axialen Abstützung dieses Gehäuses 19 aufliegt, wobei diese Positionierscheibe 12 ihrerseits durch die Stützplatte 13 gegen Wölben abgestützt ist. Im metallischen Gehäuse 19 ist ein metallischer Kolben 21 gleitbar gelagert, dessen aus dem Gehäuse 19 nach oben überstehende metallische Kolbenstange 22 eine metallische Kontaktspitze 23 aufweist, die dem Kontaktieren der ihr jeweils zugeordneten Prüfstelle von zu prüfenden Prüflingen 18 dient. Der Kolben 21 wird durch eine sich am Boden des Gehäuses 19 abstützende metallische Druckfeder 24 in aufwärtiger Richtung federbelastet. Der untere Endbereich des Gehäuses 19 ist in einer Durchgangsbohrung 30 der unteren Positionierscheibe 14 zu seiner rückwärtigen radialen Positionierung mit geringem Gleitlagerspiel gelagert. An den Boden des Gehäuses 19 ist ein dünner stabförmiger Metallstab 25 einstückig mit angeformt, der an dem Kopf 26' eines in die dicke Stützplatte 15, die aus hochfestem, starren, elektrisch isolierenden Kunststoff besteht, der rückwärtigen Gesamtplatte 17 eingesetzten metallischen Kontaktes 26 mit für guten elektrischen Kontakt ausreichender Kraft anliegt, indem dieser Kopf 26' durch eine ihn aufwärts belastende Biegefeder 27 an den Stab 25 angedrückt ist. Es ist auch möglich, diese Stäbe 25 des Gehäuses 19 durch die rückwärtige Gesamtplatte 17 unter Weglassung der Kontakte 26 hindurchzuführen und sie an die zum Auswerter weiterführenden elektrischen Leitungsdrähte 33 direkt anzuschließen bwsp. anzulöten oder sonstige elektrische Anschlüsse hierfür vorzusehen. In Fig. 1 sind die zum nicht dargestellten Auswerter weiterführenden Leitungsdrähte 33 an die Kontakte 26 angeschlossen. Jeder der beiden dünnen und hierdurch vorzugsweise biegsamen Positionierscheiben 12 und 14 der Frontgesamtplatte 16 und der rückwärtigen Gesamtplatte 17 sind für jeden Federkontaktstift 11 mit je einer gebohrten Durchgangsbohrung 29, 30 versehen, deren Durchmesser dem Außendurchmesser des zylindrischen Gehäuses 19 des jeweiligen Federkontaktstiftes 11 ungefähr entspricht, so daß hierdurch das Gehäuse 19 jedes Federkontaktstiftes 11 sowohl an seinem oberen Ende als auch an seinem unteren Ende genau positioniert und damit jeder Federkontaktstift 11 genau radial und axial positioniert ist und auch genau rechtwinklig zu den Ebenen der zueinander parallelen Gesamtplatten 16, 17 steht. Die Durchgangslöcher 29 für die Federkontaktstifte 11 der oberen Positionierscheibe 12 können dabei so dimensioniert sein, daß sie die Gehäuse 19 reibungsschlüssig lösbar halten, d.h. daß sie durch die von den Kontakten 26 ausgeübten axialen Kräfte nicht gegen den Reibungsschluß verschoben werden können, jedoch sich mittels eines an der Kolbenstange 22 oder dem Bund 20 angreifenden Werkzeuges axial aus den Gesamtplatten 16, 17 zum Auswechseln oder sonstigem Abnehmen herausziehen lassen. Da diese Positionierscheiben 12 und 14 relativ dünn sind, vorzugsweise ihre Dicken jeweils 2 bis 5 mm betragen können, sind diese Durchgangsbohrungen 29, 30 in ihnen leicht und kostengünstig trotz ihrer geringen Durchmesser von vorzugsweise 0,2 bis 1,4 mm, inbesondere von etwa 0,3 bis 1,0 mm zu bohren. Die infolge ihrer geringen Dicke relativ geringe Steifigkeit dieser Positionierscheiben 12, 14 wird ausgeglichen durch die Starrheit der sie jeweils ungefähr über ihre Breiten und Längen stützenden, viel dickeren starren Stützplatten 13, 15. Die untere Stützplatte 15 kann aus hochfestem Kunststoff oder aus Metall mit einem es elektrisch isolierenden Überzug oder dergl. hergestellt sein. Die Dicken der Stützplatten 13, 15 können bspw. zweckmäßig 15 bis 40 mm betragen. Die Länge der Kontaktstifte 11 ist wie dargestellt viel größer als die Dicke der Gesamtplatten 16, 17. Die in den Stützplatten 13, 15 befindlichen Durchgangslöcher, wie 40 und 41, die von den Federkontaktstiften 11 nicht kontaktiert werden und gleichachsig zu den mit ihnen fluchtenden Durchgangslöchern 29, 30 der Positionierscheiben 12, 14 sind, sind in ihren Durchmessern soviel größer als die Durchgangsbohrungen 29, 30 der Positionierscheiben 12, 14, daß sie trotz der wesentlich größeren Dicke dieser Stützplatten 13, 15 ebenfalls kostengünstig gebohrt werden können.

In dem Ausführungsbeispiel nach Fig. 1 und 2 ist es nicht oder nicht immer notwendig, die Scheiben 12 und 13 — bzw. die Scheiben 14 bzw. 15 — so miteinander zu verbinden, daß ihre einander benachbarten Flächen 42, 43 bzw. 44, 45 über ihre Breiten und Längen fest zusammengehalten sind. Doch kann dies erforderlichenfalls vorgesehen sein, vorzugsweise durch Zusammenkleben ihrer einander gegenüberliegenden Flächen, bspw. wenn die von den Kontakten 26 auf die Gehäuse 19 ausgeübten Kräfte relativ groß sind. Als Kleber können vorzugsweise Haftkleber vorgesehen sein.

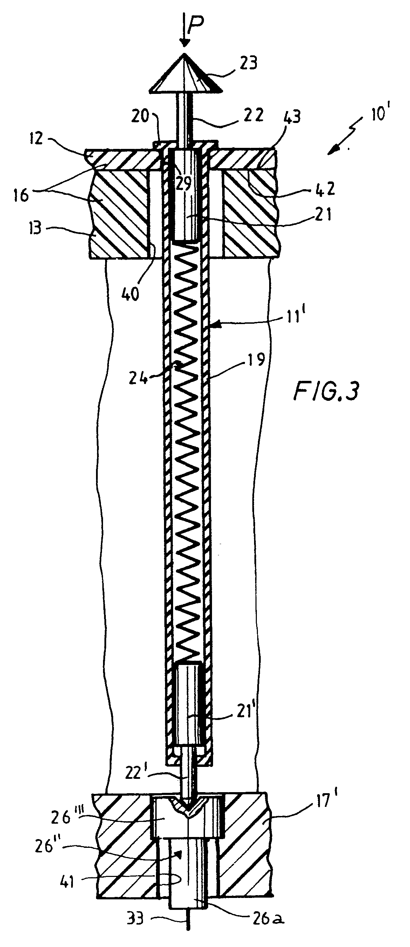

In Fig. 3 ist eine Ausführungsform eines Prüfadapters 10' ausschnittsweise dargestellt, welche sich von der nach Fig. 1 und 2 insbesondere in der Ausbildung der Federkontaktstifte, wie 11', und der rückwärtigen Gesamtplatte 17' unterscheidet. Die rückwärtige Gesamtplatte 17' besteht in diesem Ausführungsbeispiel aus einer einzigen einstückigen starren Platte 17', in die metallische elektrische Kontakte 26'', wie dargestellt, vorzugsweise fest, eingesetzt sind. Jeder Kontakt 26'' weist dabei einen zylindrischen Kopf 26'' größeren Durchmessers auf, an den ein zylindrischer Schaft 26a etwas kleineren Durchmessers anschließt, der über diese rückwärtige Gesamtplatte 17' nach unten etwas übersteht, und hier kann dann ein zum Auswerter weiterführende Leitungsdraht 33 angelötet oder auf sonstige Weise elektrisch angeschlossen sein. Dieser Kontakt 26'' dient gleichzeitig dem rückwärtigen genauen Positionieren des dargestellten Federkontaktstiftes 11', indem im rückwärtigen Längsendbereich des kreiszylindrischen Gehäuses 19 ein zweiter Kolben 21' gleitbar geradegeführt gelagert ist, der mit einer Kolbenstange 22' nach unten durch eine Bohrung des Gehäusebodens aus dem Gehäuse 19 herausragt. Auf diesen zweiten Kolben 21' stützt sich eine Druckfeder 24 ab, die auch den im oberen Längsendbereich des Gehäuses 19 gleitbar geradegeführt gelagerten ersten Kolben 21 belastet, welcher die Kolbenstange 22 und die an der Kolbenstange 22 befindliche Kontaktspitze 23 dieses Federkontaktstiftes 11' trägt. Die Druckfeder 24 belastet also beide Kolben 21, 21' gleichzeitig und drückt sie in voneinander wegführender Richtung. Die in einer Spitze auslaufende Kolbenstange 22' des unteren Kolbens 21' wird durch die Feder 24 in eine kegelförmige Pfanne des Kopfes 26'' des Kontaktes 26'' zu ihrer Justierung gedrückt. Durch diese Justierung ist es nicht erforderlich, eine gesonderte Positionierscheibe auf dieser unteren Platte 17' anzuordnen. Auch wirkt hierdurch die auf die Kontaktspitze 23 beim Prüfen eines Prüflinges von diesem axial ausgeübte Kraft (Pfeil P), durch die der obere Kolben 21 zusammen mit der Kontaktspitze 23 etwas nach unten gegen die Kraft der Feder 24 gedrückt wird, nicht über das an der Positionierscheibe 12 mittels seines Ringflansches 20 abgestützten Gehäuse 19, sondern über den unteren Kolben 21' und die untere Kolbenstange 22' auf den in der unteren Platte 17' verankerten Kontakt 26'', so daß die untere Gesamtplatte 17' diese axiale Belastungskraft P der Kontaktspitze 23 im Betrieb im wesentlichen aufnimmt und hiervon die ebene Gesamtfrontplatte 16 entlastet ist. Die wie bei Fig. 1 und 2 ausgebildete, aus einer dünnen Positionierscheibe 12 und einer diese stützenden dicken Stützplatte 13 bestehende Frontgesamtplatte 16 ist durch die Kontaktstifte 11' belastet und kann auch bei der Prüfung durch Kräfte, insbesondere Reibungskräfte in Richtung der Pfeile P mit belastet werden. Es können hier besonders zweckmäßig die Flächen 42 und 43 der Positionierscheibe 12 und der Stützplatte 13 fest zusammengehalten sein, bspw. durch Kleben. Der Kolben 21 ist in seiner oberen Stellung, in der er an der Decke des Gehäuses 19 anliegt, durch die Druckfeder 24 gegen diese Decke gedrückt, was sich in einer auf das Gehäuse 19 axial nach oben wirkenden Belastung auswirkt. Das Gehäuse 19 kann gegen Verschieben nach oben gehalten werden. Dies kann vorzugsweise dadurch erfolgen, indem der Durchmesser der Durchgangsbohrung 29 der oberen Positionierscheibe 12 so auf den Durchmesser des in ihr befindlichen Gehäuseabschnittes abgestimmt ist, daß dieses Gehäuse 19 in dieser Positionierscheibe 12 durch Haftreibung ausreichend fest gehalten ist, um sich nicht durch den Druck der Feder 24 nach oben verschieben zu lassen, wobei dieser Reibungssitz jedoch nur so fest ist, daß er nicht das Auswechseln des Federkontaktstiftes 11' im ganzen behindert. Die Stützplatte 13 bewirkt hier also, daß sie bei unbelasteter Kontaktspitze 23 im Falle fest zusammengehaltener Flächen 42, 43 Auswölben der Positionierscheibe 12 durch die Kräfte der Federn 24 nach oben verhindert, und bei nach unten gedrückten Kontaktspitzen 23 stützt sie die Positionier scheibe 12 gegen Auswölben nach unten ab. Auch das Verhindern des Auswölbens der Scheibe 12 nach oben durch die Stützplatte 13 sei als Stützung der Scheibe 12 durch die Platte 13 bezeichnet.

Obwohl in den Ausführungsbeispielen die Positionierscheiben 12 der Frontgesamtplatten 16 die jeweils den Kontaktspitzen 23 der Kontaktstifte 11, 11' benachbarten Scheiben sind, was meist besonders vorteilhaft ist, kann in manchen Fällen es auch zweckmäßig sein, die Stützplatte 13 der Frontgesamtplatte 16 benachbart den Kontaktspitzen 23 der Kontaktstifte 11 bzw. 11' anzuordnen. So ist im Ausführungsbeispiel nach Fig. 3 bei unbelasteten Kontaktspitzen 23 das an der oberen Positionierscheibe 12 reibungsschlüssig gehaltene Gehäuse 19 durch die Feder 24 mit deren Vorspannung in aufwärtiger Richtung belastet und es kann dann oft vorteilhaft sein, die Positionierscheibe 12 unter der Stützplatte 13, d.h. auf ihrer der rückwärtigen Gesamtplatte 17' zugewendeten Seite, anstatt, wie dargestellt, über ihr anzuordnen.

Bei dem Ausführungsbeispiel nach Fig. 1 und 2 ist insbesondere dann keine feste Verbindung, bspw. keine Verkleben, der aneinander anliegenden Flächen der Positionierscheibe 12 und der Stützplatte 13 erforderlich, wenn die Drähte 33 direkt unter Weglassung der Kontakte 26 an die Anschlußenden 25 der Federkontaktstifte 11 angeschlossen sind, und es kann dann oft auch die Stützplatte 15 und in manchen Fällen auch die Positionierscheibe 14 weggelassen werden.

In den beschriebenen Ausführungsbeispielen nach den Fig. 1 bis 3 dient die jeweils als Platte ausgebildete Positionierscheibe 12 der Frontgesamtplatte 16 sowohl der axialen als auch der radialen Positionierung des Gehäuses 19 in ihrem Bereich und auch dem Halten des Gehäuses gegen die von der Feder 24 ausgeübten und sonstigen im Betrieb auftretenden Kräfte. Es ist jedoch auch möglich, vorzusehen, daß das Gehäuse 19 des Federkontaktstiftes 11 bzw. 11' in der zugeordneten Bohrung 29 der Positionierscheibe 12 mit geringem Gleitlagerspiel axial beweglich angeordnet ist, was das Einsetzen und Herausnehmen des Federkontaktstiftes noch weiter erheblich erleichtert und vereinfacht. Diese Positionierscheibe 12 dient dann zwar weiterhin dem ständigen radialen Positionieren des Gehäuses 19 in ihr. Sie braucht jedoch nicht mehr dem ständigen axialen Halten des Federkontaktstiftes zu dienen. Sie dient dabei jedoch noch dem axialen Abstützen des Gehäuses 19 in Abwärtsrichtung, sei es ständig oder nur während Prüfvorgängen, bei denen die Kontaktspitze 23 mit dem Kolben 21 durch Prüflinge nach unten gedrückt wird. Dies sei anhand von nicht dargestellten Abwandlungen der Fig. 2 und 3 an einigen Ausführungsbeispielen noch näher erläutert.

In solchen Fällen ist vorgesehen, daß der Prüfadapter 10, 10' nur in solcher Stellung oder Stellungen eingesetzt wird, bei der oder denen die Kontaktspitzen 23 der Federkontaktstifte 11 bzw. 11' vertikal oder schräg nach aufwärts gerichtet sind, so daß die Federkontaktstifte, wenn ihre Gehäuse 19 in den zugeordneten Durchgangslöchern der Positionierscheiben 12 der Frontgesamtplatten mit geringem Gleitlagerspiel geführt sind und sie auch nicht an anderen Stellen, bspw. an der rückwärtigen Gesamtplatte 17 gegen Abnehmen von ihr gesichert sind, nicht aus dem Prüfadapter 10, 10' herausfallen können, sondern sich infolge ihres Eigengewichtes im Prüfadapter halten, sei es durch Abstützung an der Frontgesamtplatte 16 mittels ihrer Gehäuseringbunde 20 oder sonstiger Verbreiterungen der Gehäuse 19 an dieser Stelle und/oder durch Abstützung an der unteren Gesamtplatte 17 bzw. auf oder an elektrischen Kontakten od. dergl., die an der Gesamtplatte 17 oder auf sonstige Weise gehalten sein können.

Beim Ausführungsbeispiel nach Fig. 1 und 2 ist also dann das Gehäuse 19 nicht nur in der Durchgangsbohrung 30 der unteren Positionierscheibe 14 mit geringem Gleitlagerspiel geführt, sondern auch in der Durchgangsbohrung 29 der oberen Positionierscheibe 12. Die Feder 27 kann dann bei unbelasteter Kontaktspitze 23 den Federkontaktstift 11 unter Abheben des Ringbundes 20 seines Gehäuses 19 von der Positionierscheibe 12 nach oben drücken. Wenn ein Prüfling bei einer Prüfung die Kontaktspitze 23 mit dem Kolben 21 jedoch nach unten drückt, wird hierdurch der Kolben 21 relativ zum Gehäuse axial nach unten unter stärkerem Zusammendrücken der Feder 24 gedrückt, und diese Feder 24 drückt das Gehäuse 19 und damit den Metallstab 25 axial nach unten gegen den Kontakt 26', welcher so unter stärkerem Zusammendrücken der Feder 27 mit entsprechend großer Kraft durch den Metallstab 25 belastet wird, so daß hier guter elektrischer Kontakt während jedes Prüfvorganges besteht. Dabei ist auch zu berücksichtigen, daß der den Federkontaktstift 11 durchströmende Prüfstrom bei solchen Prüfungen in der Regel immer erst dann eingeschaltet wird, wenn der zu prüfende Prüfling seine die Kontaktspitze 23 des Federkontaktstiftes 11 am weitesten nach unten drückende Endstellung erreicht hat, in der die Prüfung durchgeführt wird.

Es ist bei der Ausführungsform nach Fig. 1 und 2 jedoch oft auch eine Abwandlung zweckmäßig, bei der der elektrische Kontakt 26 nicht durch die Feder 27 etwas nach oben federnd gedrückt ist, sondern in der unteren Stützplatte 15 unbeweglich gehalten oder zumindest gegen axiale Relativverschiebung nach unten gehalten ist, zu welchem Zweck die Feder 27 weggelassen wird und der Kopf 26' mit seinem unteren Bund auf der Ringschulter der Durchgangsbohrung 41 der Stützplatte 15 aufsitzen kann. Es kann auch vorgesehen sein, die Feder 24 kürzer als dargestellt zu treffen, derart, daß der Kolben 21 nicht an die den Ringbund 20 aufweisende obere Stirnwand des Gehäuses gedrückt wird, sondern sich der Kolben 21 ständig im Abstand unterhalb der oberen Stirnwand des Gehäuses 19 befindet.

Ähnliche Abwandlungen können auch bei der Ausführungsform nach Fig. 3 vorgesehen sein.

So kann hier ebenfalls die Feder 24 so kurz sein, daß der Kolben 21 bei nach oben gerichteter Kontaktspitze 23 nicht an der den Ringbund 20 aufweisenden oberen Stirnwand des Gehäuses 19 zur Anlage kommt, sondern sich im Abstand von ihr befindet, bspw. in der unbelasteten Stellung der Kontaktspitze 23 im Abstand von 1 bis 2 mm. Das Gehäuse 19 kann ebenfalls in der zugeordneten Durchgangsbohrung 29 der Positionierscheibe 12 mit Gleitlagerspiel gelagert sein. Der Ringbund 20 liegt dann ständig infolge des Eigengewichtes des Gehäuses 19 auf der Oberseite der Positionierscheibe 12 auf. Das Anschlußende 22' liegt bei unbelasteter Kontaktspitze 23 dann nur mit dem Eigengewicht des Federkontaktstiftes 11' abzüglich des Gewichtes seines Gehäuses 19 auf dem Kontakt 26'' auf. Wenn jedoch bei Durchführung einer Prüfung der Federkontaktstift 23 durch den Prüfling mit der Kraft P nach unten unter Zusammendrücken der Feder 24 gedrückt wird, wird hierdurch das Anschlußende 22' mit entsprechend großer Kraft auf den Anschlußkontakt 26'' axial angedrückt und hierdurch ebenfalls wieder guter elektrischer Kontakt während der einzelnen Prüfvorgänge von Prüflingen sichergestellt.

Das Ausführungsbeispiel nach Fig. 3 kann auch noch in anderer Weise abgewandelt werden, wobei ebenfalls die Kontaktspitze 23 nach oben gerichtet ist und das Gehäuse 19 in der Durchgangsbohrung der Positionierscheibe 12 mit engem Gleitlagerspiel geführt ist. Bei dieser Abwandlung ist die Feder 24 so lang, daß sie bei unbelasteter Kontaktspitze 23 den oberen Kolben 21 bis zum Anliegen an die den Ringbund 20 aufweisende obere Stirnwand des Gehäuses 19 drückt, und das Gehäuse 19 etwas nach oben bewegt wird, bis der Kolben 21' an dem Boden des Gehäuses 19 zur Anlage kommt. Hierdurch wird der Ringbund 20 von der Positionierscheibe 12 nach oben entsprechend weit abgehoben. Die Feder 24 ist ständig vorgespannt. Wenn nun die Kontaktspitze 23 durch einen Prüfling mit dem Kolben 21 nach unten bewegt wird, dann kann das Gehäuse 19 axial nach unten wandern, bis sein Ringbund 20 auf der Positionierscheibe 12 aufliegt. Der Boden des Gehäuses 19 befindet sich dann, wie in Fig. 3, im Abstand unterhalb des Kolbens 21', und dieser Kolben 21' wird mit einer der axialen Belastungskraft P der Kontaktspitze 23 ungefähr entsprechenden Kraft nach unten und damit das Anschlußende 22' mit entsprechender Kraft an den Anschlußkontakt 26'' gedrückt. Diese starke Anpreßkraft tritt also ebenfalls nur während jeder einzelnen Prüfung auf und, solange die Kontaktspitze 23 nicht belastet ist, ist die Kraft, mit der das Anschlußende 22' an den Anschlußkontakt 26'' axial angedrückt wird, nur gering, nämlich etwa entsprechend dem Eigengewicht des Federkontaktstiftes 11'.

Die Lagerung des Gehäuses 19 in der Durchgangsbohrung der Positionierscheibe 12 mit geringem Gleitlagerspiel hat u.a. den Vorteil, daß bei weiterhin guter radialer Positionierung dieses Gehäuses 19 in der Positionierscheibe 12 das Auswechseln des Federkontaktstiftes 11, 11' noch einfacher und rascher erfolgen kann, weil beim Herausziehen des Federkontaktstiftes 11 bzw. 11' aus dem Prüfadapter praktisch nur das Eigengewicht und keine größere Haftreibung des Federkontaktstiftes 11 bzw. 11' im Prüfadapter 10 bzw. 10' zu überwinden ist. Die Frontgesamtplatte 16 ist dann auch durch die Federkontaktstifte 11 bzw. 11' geringer belastet und die Stützplatte 13 und die Positionierscheibe 12 können hierdurch dünner ausgeführt werden, was ihre Herstellung verbilligt. Diese Stützplatte 13 ist jedoch weiterhin vorzusehen, weil sie für die genaue Positionierung und Abstützung der Scheibe 12 weiterhin notwendig oder zweckmäßig ist. Auch genügt es bei den vorbeschriebenen Abwandlungen der Fig. 1 bis 3 zumindest oft, wenn die Positionierscheibe 12 nur auf der Stützplatte 13 aufliegt, ihre einander benachbarten Flächen also nicht durch Kleben oder auf sonstige Weise über ihre Flächenerstreckungen zusammengehalten sind. Dann genügt also, wenn die beiden Scheiben 12 und 13 nur an ihren Randbereichen am Gestell des Prüfadapters gehalten und keine sonstigen Verbindungsmittel zwischen ihnen vorgesehen sind. Oder es genügt, sie nur an ihren Randbereichen so miteinander zu verbinden, daß sie eine in das Gestell des Prüfadapters einsetzbare Baueinheit bilden. Es kann also bevorzugt vorgesehen sein, daß die Positionierscheibe 12 und die Stützplatte 13 der Frontgesamtplatte 16 nur außerhalb ihrer der Aufnahme der Kontaktstifte 11 bzw. 11' dienenden Bereiche zusammengehalten sind, sei es direkt zur Bildung einer in das Gestell des Prüfadapters einsetzbaren Baueinheit oder indirekt mittels des Gestells des Prüfadapters oder auf sonstige Weise. Wenn die Positionierscheibe 12 im wesentlichen nur mit dem Eigengewicht der Kontaktstifte 11 oder ihrer Gehäuse zuzüglich Reibungskräften des oder der Kolben belastet ist, kann sie besonders dünn ausgebildet werden, so daß sie dann keine Platte mehr ist, sondern nur noch eine dünne bis extrem dünne Scheibe, oft zweckmäßig nur noch ein Blatt oder eine Folie sein kann, was ihre Herstellung noch weiter verbilligen kann.

Jeder der dargestellten Federkontaktstifte 11, 11' weist ein Gehäuse 19 mit einem einzigen zylindrischen Mantel auf, an den oberseitig ein Ringbund 20 anschließt. Dieser Mantel ist direkt in die zugeordnete Bohrung 29 der betreffenden Positionierplatte 12 eingesetzt. Es ist aber auch möglich, diesen Mantel des Kontaktstiftes als Innenmantel in eine einen Außenmantel des Gehäuses bildende Hülse oder dergl. formschlüssig lösbar einzusetzen, die in die Bohrung 29 eingesetzt wird und kürzer, gleich lang oder länger als der Innenmantel sein kann, so daß dann das Gehäuse des Kontaktstiftes, welcher Kontaktstift ein Federkontaktstift oder ein sonstiger Kontaktstift sein kann, einen Außenmantel und einen Innenmantel aufweist. Dieser Außenmantel kann bspw. einen Ringflansch aufweisen, der an der Oberseite der Frontgesamtplatte anliegt.

Anstelle der Federkontaktstifte 11, 11' mit langen Gehäusen 19 oder zusätzlich können auch Kontaktstifte anderer Bauarten vorgesehen werden. Bspw. kann die Kontaktspitze oft die Spitze einer langen, starren oder in sich axial federnden Kontaktnadel oder eines als Kontaktstift dienenden Drahtes sein, die bzw. der in dem Längsabschnitt 29 des kleineren Durchmessers der Frontgesamtplatte, d.h. im Falle der in den Ausführungsbeipielen dargestellten Frontgesamtplatten in der zugeordneten Bohrung 29 der Positionierscheibe 12 gleitbar axial geführt oder im Bereich der Positionierscheibe 12 in einer in die zugeordnete Durchgangsbohrung 29 dieser Positionierscheibe eingesetzten, vorzugsweise kurzen metallischen oder nichtmetallischen Führungshülse mit geringem Gleitlagerspiel geradegeführt ist. Diese Führungshülse kann sich im wesentlichen nur über die Länge der Durchgangsbohrung 29 erstrecken oder auch beliebig länger sein. Diese Kontaktnadel kann, wenn sie starr ist, bspw. sich an einer an der rückwärtigen Gesamtplatte abstützenden, freiliegenden Rückstellfeder federnd abgestützt sein.

Die Positionierscheibe kann bspw. vorteilhaft aus elektrisch isolierendem, leicht und genau zu bohrendem polymerem Methacrylsäuremethylester, wie er von Firma Röhm & Haas, Darmstadt, unter dem Handelsnamen Plexiglas vertrieben wird, und die Stützplatte aus hochfestem, glasfaserverstärktem Epoxidharz bestehen, das zwar schwerer als Plexiglas zu bohren ist, was jedoch wegen der größeren Bohrungsdurchmesser und der hier dann vorzugsweise geringeren Bohrungstiefe und der geringeren erforderlichen Bohrungsgenauigkeit ebenfalls kostengünstig möglich ist.

Wie aus der Zeichnung ferner ersichtlich ist, sind die Bohrungen 40, 41 der Stützplatten 13, 15 unabgedeckt, also jeweils nach unten offen, was besonders zweckmäßig ist.

Die Länge des einzelnen Kontaktstiftes 11 bzw. 11' kann zweckmäßig mindestens das 3-fache, vorzugsweise mindestens das 4-fache der Dicke der Frontgesamtplatte 16 betragen. Auch dann, wenn der Kontaktstift keine Federkontaktstift ist, sondern ein anders ausgebildeter Kontaktstift, kann seine Länge ebenfalls zweckmäßig mindestens das 3-fache, vorzugsweise mindestens das 4-fache der Dicke der Frontgesamtplatte betragen.

**Patentansprüche**

1. Prüfadapter für eine Prüfeinrichtung zum elektrischen Prüfen von elektrischen, vorzugsweise elektronischen Prüflingen (18), wie elektrischen oder elektronischen Schaltungen und Schaltkreisen, Leiterplatten, festen Verdrahtungen, auf elektrische Fehlerfreiheit, welcher Prüfadapter (10) eine ebene, dicke Frontgesamtplatte (16) aufweist, welche eine sehr große Anzahl Durchgangslöcher aufweist, welche von elektrisch leitenden, im Prüfadapter gegeneinander elektrisch isolierten Kontaktstiften, vorzugsweise Federkontaktstiften durchdrungen sind, die im Bereich der Durchgangslöcher der Frontgesamtplatte vorzugsweise maximal 1,4 mm Außendurchmesser aufweisen, welche Kontaktstifte je eine Kontaktspitze (23) aufweisen, die gegen Rückstellkräfte, vorzugsweise gegen Federwirkung axial in Richtung auf die Frontgesamtplatte (16) zu beweglich sind, dadurch gekennzeichnet, daß die Kontaktstifte (11; 11') im Prüfadapter (10) so angeordnet sind, daß sie ohne dessen Demontage lösbar sind, daß die Durchgangslöcher (29, 40) der Frontgesamtplatte (16) für diese Kontaktstifte (11; 11') aus je einem Längsabschnitt (29), dessen Durchmesser dem Außendurchmesser des in diesem Lochabschnitt befindlichen Bereiches des Kontaktstiftes zur radialen und/oder axialen Positionierung des in ihm befindlichen Bereiches des Kontaktstiftes ungefähr entspricht, und je einem restlichen Längsabschnitt (40), dessen Länge und Durchmesser größer als die Länge und der Durchmesser des anderen Längsabschnittes (29) sind, bestehen, daß die Frontgesamtplatte (16) aus zwei gesonderten ebenen Scheiben (12, 13) zusammengesetzt ist, die aneinander anliegen und von denen die eine Scheibe eine in ihrem Bereich der radialen und/oder der axialen Positionierung und der axialen Stützung der Kontaktstifte (11; 11') dienende, die Längsabschnitte der kleineren Durchmesser der Durchgangslöcher der Frontgesamtplatte aufweisende Positionierscheibe (12) für die Kontaktstifte ist, und daß die andere Scheibe der Frontgesamtplatte (16) eine starre Stützplatte (13) für die an ihr anliegende Positionierscheibe (12) ist, welche Stützplatte die restlichen Längsabschnitte (40) mit dem größeren Durchmesser der Durchgangslöcher der Frontgesamtplatte aufweist, die von den betreffenden Kontaktstiften (11; 11') berührungslos durchdrungen sind.

2. Prüfadapter nach Anspruch 1, dadurch gekennzeichnet, daß der Prüfadapter (10; 10') im Abstand von der Frontgesamtplatte (16) eine ebene, zu dieser Frontgesamtplatte parallele, rückwärtige Gesamtplatte (17; 17') aufweist, die der rückwärtigen radialen und/oder axialen Positionierung der Kontaktstifte (11; 11') und/oder deren axialer Stützung dient und/oder dem elektrischen Anschluß der Kontaktstifte dienende Anschlußkontakte (26; 26'') trägt.

3. Prüfadapter nach Anspruch 2, dadurch gekennzeichnet, daß die rückwärtige Gesamtplatte (17) Durchgangsbohrungen aufweist, die jeweils einen Längsabschnitt zur radialen und/oder axialen Positionierung des Kontaktstiftes und einen restlichen Längsabschnitt, dessen Länge und Durchmesser größer als die Länge und der Durchmesser des anderen Längsabschnittes ist, aufweisen, wobei die rückwärtige Gesamtplatte (17) aus zwei ebenen, gesonderten Scheiben (14, 15) zusammengesetzt ist, von denen die eine Scheibe eine Positionierscheibe (14) für die Kontaktstifte (11) und die andere Scheibe (15) eine an dieser Positionierscheibe (14) anliegende starre Stützplatte (15) für diese Positionierscheibe (14) ist, wobei diese Positionierscheibe (14) Durchgangsbohrungen aufweist, deren Durchmesser dem Durchmesser von in ihnen befindlichen Bereichen der Kontaktstifte ungefähr entsprechen und die diejenigen Längsabschnitte der Durchgangsbohrungen der rückwärtigen Gesamtplatte (17) sind, die der radialen und/oder axialen Positionierung der Kontaktstifte dienen, und daß die rückwärtige Stützplatte vorzugsweise Anschlußkontakte (26) für den elektrischen Anschluß der Kontaktstifte (11) trägt.

4. Prüfadapter nach einem der vorhergehenden Ansprüche, dadurch gekennzeichnet, daß die Dicke der Positionierscheibe (12; 14) der Frontgesamtplatte (16) bzw. der Frontgesamtplatte (16) und/oder der rückwärtigen Gesamtplatte (17) wesentlich weniger als die halbe Dicke der Frontgesamtplatte (16) bzw. der rückwärtigen Gesamtplatte (17) beträgt, vorzugsweise 1/20 bis 1/3 der Dicke der zugeordneten Stützscheibe.

5. Prüfadapter nach Anspruch 2, 3 oder 4, bei dem die rückwärtige Gesamtplatte (17, 17') dem elektrischen Anschluß der Kontaktstifte dienende Anschlußkontakte trägt dadurch gekennzeichnet, daß die elektrischen Anschlußkontakte (26'') der rückwärtigen Gesamtplatte (17') den Zentrieren der in sie eingreifenden und mit ihnen in elektrischem Kontakt stehenden rückwärtigen Anschlußenden (22') der Kontaktstifte (11') dienen.

6. Prüfadapter nach einem der vorhergehenden Ansprüche, dadurch gekennzeichnet, daß zumindest eine Teilanzahl der Kontaktstifte (11; 11'), vorzugsweise die meisten oder alle solchen Kontaktstifte Gehäuse (19) oder Führungshülsen aufweisen, die in den die kleineren Durchmesser aufweisenden Längsabschnitten (29) der zugeordneten Durchgangslöcher (29, 40) der Frontgesamtplatte (16) lösbar angeordnet sind.

7. Prüfadapter nach Anspruch 6, dadurch gekennzeichnet, daß die Gehäuse oder Führungshülsen der Kontaktstifte in den die kleineren Durchmesser aufweisenden Längsabschnitten (29) der zugeordneten Durchgangslöcher (29, 40) der Frontgesamtplatte (16) reibungsschlüssig lösbar gehalten oder mit geringem Gleitlagerspiel geführt sind.

8. Prüfadapter nach Anspruch 6 oder 7, dadurch gekennzeichnet, daß das Gehäuse (19) oder die Führungshülse des Kontaktstiftes (11; 11') einen Ringbund (20) aufweist, der der axialen Abstützung des Gehäuses (19) bzw. der Führungshülse an der Frontgesamtplatte (16), vorzugsweise an ihrer Positionierscheibe (12) dient oder dienen kann.

9. Prüfadapter nach einem der vorhergehenden Ansprüche, dadurch gekennzeichnet, daß die Positionierscheibe (12) der Frontgesamtplatte (16) den Kontaktspitzen (23) der Kontaktstifte (11; 11') benachbart angeordnet ist.

10. Prüfadapter nach einem der vorhergehenden Ansprüche, dadurch gekennzeichnet, daß die Positionierscheibe (12) und die Stützplatte (13) der Frontgesamtplatte (16) nur außerhalb ihrer der Aufnahme der Kontaktstifte (11; 11') dienenden Bereiche zusammengehalten sind.

11. Prüfadapter nach einem der Ansprüche 6—10, dadurch gekennzeichnet, daß zumindest eine Teilanzahl der Kontaktstifte, vorzugsweise die meisten oder alle solchen Kontaktstifte lösbar gehaltene Federkontaktstifte (11; 11') sind, wobei der einzelne Federkontaktstift einen mit seiner Kontaktspitze (23) fest verbundenen Kolben (21) aufweist, der im geraden Gehäuse (19) dieses Federkontaktstiftes axial beweglich geführt und durch eine im Gehäuse angeordnete, sich vorzugsweise am Gehäuse abstützende Feder (24) axial federbelastbar oder federbelastet ist.

12. Prüfadapter nach Anspruch 11, dadurch gekennzeichnet, daß der Federkontaktstift (11') an dem vom die Kontaktspitze (23) tragenden Kolben (21) abgewendeten Endbereich des Gehäuses (19) einen weiteren im Gehäuse axial gleitbar gelagerten Kolben (21') aufweist, der durch dieselbe Feder (24) wie der andere Kolben (21) federbelastet oder -belastbar ist und an dem ein dem elektrischen Anschluß des Federkontaktstiftes dienendes Anschlußglied (22') angeordnet ist, das vorzugsweise stangenförmige Gestalt aufweist.

13. Prüfadapter nach einem der vorhergehenden Ansprüche, dadurch gekennzeichnet, daß die Länge desjenigen Längsabschnittes (29) der Durchgangsbohrung der Frontgesamtplatte bzw. der Durchgangsbohrung der Frontgesamtplatte und/oder der Durchgangsbohrung der rückwärtigen Gesamtplatte, dessen Durchmesser dem Außendurchmesser des in ihm befindlichen Bereiches des Kontaktstiftes ungefähr entspricht, ungefähr 0,1 bis 5 mm beträgt.

14. Prüfadapter nach einem der vorhergehenden Ansprüche, dadurch gekennzeichnet, daß die Positionierscheibe (12; 14) der Frontgesamtplatte bzw. der Frontgesamtplatte und/oder der rückwärtigen Gesamtplatte eine Platte, ein Blatt oder eine Folie ist.

15. Prüfadapter nach einem der vorhergehenden Ansprüche, dadurch gekennzeichnet, daß zumindest eine Teilanzahl der Kontaktstifte (11; 11'), vorzugsweise die meisten oder alle solchen Kontaktstifte jeweils als eine Nadel oder als Draht ausgebildet sind, die bzw. der in dem Längsabschnitt des kleineren Durchmessers des betreffenden Durchgangsloches (29) der Frontgesamtplatte gleitbar geführt ist.

16. Prüfadapter nach einem der vorhergehenden Ansprüche, dadurch gekennzeichnet, daß die Kontaktstifte oder eine Teilanzahl von ihnen jeweils einen einzigen Mantel aufweisen oder einen Innenmantel, der in einem Außenmantel eines Gehäuses lösbar angeordnet ist.

17. Prüfadapter nach einem der vorhergehenden Ansprüche, dadurch gekennzeichnet, daß die Länge zumindest einer Teilanzahl der Kontaktstifte, vorzugsweise der meisten oder aller solchen Kontaktstifte (11; 11') wesentlich größer als die Dicke der Frontgesamtplatte (16) bzw. der Frontgesamtplatte (16) oder der rückwärtigen Gesamtplatte (17) ist.

18. Prüfadapter nach Anspruch 17, dadurch gekennzeichnet, daß die Länge des Kontaktstiftes (11; 11') mindestens das 3-fache, vorzugsweise mindestens das 4-fache der Dicke der Frontgesamtplatte (16) beträgt.

19. Prüfadapter nach einem der vorhergehenden Ansprüche, dadurch gekennzeichnet, daß zumindest eine Teilanzahl der Kontaktstifte (11; 11'), vorzugsweise die meisten oder alle solchen Kontaktstifte beidseits über die Frontgesamtplatte (12) überstehen.

**Revendications**

1. Adaptateur d'essai destiné à un appareil d'essai pour vérifier électriquement l'absence de défauts électriques d'échantillons électriques (18), et de préférence électroniques, comme des montages et des circuits électriques et électroniques, des cartes de circuits imprimés ou des câblages fixes, ledit adaptateur d'essai (10) comportant une platine composée avant (16), plane et épaisse, présentant un très grand nombre de passages traversés par des tiges de contact, et de préférence par des tiges de contact à ressort, qui sont conductrices de l'électricité et isolées électriquement les unes des autres dans l'adaptateur d'essai, qui présentent de préférence un diamètre extérieur maximal de 1,4 mm dans la région des passages de la platine composée avant, et qui comportent chacune une pointe de contact (23) pouvant être déplacée axialement dans la direction de la platine composée avant (16) à l'encontre de forces de rappel, et de préférence à l'encontre de l'effet d'un ressort, caractérisé par le fait que les tiges de contact (11; 11') sont disposées dans l'adaptateur d'essai (10) de manière à pouvoir être détachées sans qu'elles soient démontées, par le fait que les passages (29, 40) ménagés dans la platine composée avant (16) pour ces tiges de contact (11; 11') se composent, pour chacun, d'une portion longitudinale (29) dont le diamètre correspond à peu près au diamètre extérieur de la région de la tige de contact qui se trouve dans cette portion du passage en vue du positionnement radial et/ou axial de la région de la tige de contact qui se trouve dans lui, et, pour chacun, d'une portion longitudinale restante (40) dont la longueur et le diamètre sont supérieurs à la longueur et au diamètre de l'autre portion longitudinale (29), par le fait que la platine composée avant (16) est formée par l'assemblage de deux plaques planes (12, 13), séparées et contiguës l'une à l'autre, dont l'une est une plaque de positionnement (12) qui est destinée aux tiges de contact, qui sert dans sa zone au positionnement radial et/ou axial et à l'appui axial des tiges de contact (11; 11'), et qui comporte les portions longitudinales de plus petit diamètre des passages de la platine composée avant, et par le fait que l'autre plaque de la platine composée avant (16) est une plaque rigide (13) destinée à l'appui de la plaque de positionnement contiguë à elle (12), ladite plaque d'appui comportant les portions longitudinales restantes (40) de plus grand diamètre des passages de la platine composée avant qui sont traversées sans contact par les tiges de contact concernées (11; 11').

2. Adaptateur d'essai selon la revendication 1, caractérisé par le fait que l'adaptateur d'essai (10; 10') comporte, à distance de la platine composée avant (16), une platine composée arrière (17; 17') qui est plane et parallèle à cette platine composée avant, qui sert au positionnement arrière radial et/ou axial des tiges de contact (11; 11') et/ou à leur appui axial, et/ou qui porte des contacts de raccordement (26; 26'') servant au raccordement électrique des tiges de contact.

3. Adaptateur d'essai selon la revendication 1, caractérisé par le fait que la platine composée arrière (17) comporte des passages qui présentent chacun une portion longitudinale pour le positionnement radial et/ou axial de la tige de contact et une portion longitudinale restante dont la longueur et le diamètre sont supérieurs à la longueur et au diamètre de l'autre portion longitudinale, la platine composée arrière (17) étant formée par l'assemblage de deux plaques planes séparées (14, 15) dont l'une est une plaque de positionnement (14) pour les tiges de contact (11), et dont l'autre (15) est une plaque d'appui rigide (15) destinée à cette plaque de positionnement (14) et contiguë à cette plaque de positionnement (14), cette plaque de positionnement (14) présentant des passages dont les diamètres correspondent à peu près au diamètre des tiges de contact situées dans leurs régions et qui sont les portions longitudinales des passages de la platine composée arrière (17) servant au positionnement radial et/ou axial des tiges de contact, et par le fait que la plaque d'appui arrière porte de préférence des contacts de raccordement (26) pour le raccordement électrique des tiges de contact (11).

4. Adaptateur d'essai selon l'une des revendications précédentes, caractérisé par le fait que l'épaisseur de la plaque de positionnement (12; 14) de la platine composée avant (16) ou, respectivement, de la platine composée avant (16) et/ou de la platine composée arrière (17) est nettement inférieure à la moitié de l'épaisseur de la platine composée avant (16) ou, respectivement, de la platine composée arrière (17), et qu'elle s'élève de préférence à 1/20 à 1/3 de l'épaisseur de la plaque de protection associée.

5. Adaptateur d'essai selon la revendication 1, 3 ou 4, dans lequel la platine composée arrière (17; 17') porte des contacts de raccordement servant au raccordement électrique des tiges de contact, caractérisé par le fait que les contacts de raccordement électrique (26'') de la platine composée arrière (17) servent à centrer les extrémités de raccordement arrière (22') des tiges de contact (11') qui pénètrent dans eux et qui sont en contact électrique avec eux.

6. Adaptateur d'essai selon l'une des revendications précédentes, caractérisé par le fait qu'au moins une partie des tiges de contact (11; 11'), et de préférence la plupart de ces tiges de contact ou toutes, comportent des enveloppes (19) ou des manchons de guidage qui sont disposés de manière amovible dans les portions longitudinales (29) des passages associés (29, 40) de la platine composée avant (16) qui présentent le plus petit diamètre.

7. Adaptateur d'essai selon la revendication 6, caractérisé par le fait que les enveloppes ou les manchons de guidage des tiges de contact sont maintenus de manière amovible par frottement ou sont guidés avec un faible jeu analogue à celui d'un palier à glissement dans les portions longitudinales (29) des passages associés (29, 40) de la platine composée avant (16) qui présentent le plus petit diamètre.

8. Adaptateur d'essai selon la revendication 6 ou 7, caractérisé par le fait que l'enveloppe (19) ou le manchon de guidage de la tige de contact (11; 11') comporte un collet annulaire (20) qui sert ou qui peut servir à l'appui axial de l'enveloppe (19) ou du manchon de guidage, respectivement, sur la platine composée avant (16), et de préférence sur sa plaque de positionnement (12).

9. Adaptateur d'essai selon l'une des revendications précédentes, caractérisé par le fait que la plaque de positionnement (12)·de la platine composée avant (16) est disposée au voisinage des pointes de contact (23) des tiges de contact (11; 11').

10. Adaptateur d'essai selon l'une des revendications précédentes, caractérisé par le fait que la plaque de positionnement (12) et la plaque d'appui (13) de la platine composée avant (16) ne sont assemblées qu'à l'extérieur de leurs zones qui servent à recevoir les tiges de contact (11; 11').

11. Adaptateur d'essai selon l'une des revendications 6 à 10, caractérisé par le fait qu'au moins une partie des tiges de contact, et de préférence la plupart de ces tiges de contact ou toutes, sont des tiges de contact à ressort (11; 11') maintenues de manière amovible, chaque tige de contact à ressort comportant un piston (21) qui est solidaire de sa pointe de contact (23), qui est guidé en étant mobile axialement dans l'enveloppe rectiligne (19) de cette tige de contact à ressort, et qui est ou qui peut être soumis à une charge élastique axiale par un ressort (24) disposé dans l'enveloppe et s'appuyant de préférence sur l'enveloppe.

12. Adaptateur d'essai selon la revendication 11, caractérisé par le fait que la tige de contact à ressort (11') comporte, dans la région de l'extrémité de l'enveloppe (19) qui est opposée au piston (21) portant la pointe de contact (23), un autre piston (21') qui est monté en glissement axial dans l'enveloppe, qui est ou qui peut être chargé élastiquement par le même ressort (24) que l'autre piston (21), et sur lequel est monté un organe de raccordement (22'), lequel sert au raccordement électrique de la tige de contact à ressort et présente de préférence la forme d'une tige.

13. Adaptateur d'essai selon l'une des revendications précédentes, caractérisé par le fait que la longueur de la portion longitudinale (29) du passage de la platine composée avant ou, respectivement, du passage de la platine composée avant et/ou du passage de la platine composée arrière, dont le diamètre correspond à peu près au diamètre extérieur de la zone de la tige de contact qui se trouve dans lui, est d'environ 0,1 à 5 mm.

14. Adaptateur d'essai selon l'une des revendications précédentes, caractérisé par le fait que la plaque de positionnement (12; 14) de la platine composée avant ou, respectivement, de la platine composée avant et/ou de la platine composée arrière, est une plaque, une feuille ou une pellicule.

15. Adaptateur d'essai selon l'une des revendications précédentes, caractérisé par le fait qu'au moins une partie des tiges de contact (11; 11'), et de préférence la plupart de ces tiges de contact ou toutes, sont à chaque fois réalisées sous la forme d'une aiguille ou d'un fil qui est guidé en glissement dans la portion longitudinale de plus petit diamètre du passage concerné (29) de la platine composée avant.

16. Adaptateur d'essai selon l'une des revendications précédentes, caractérisé par le fait que les tiges de contact, ou une partie d'entre elles, comportent à chaque fois une gaine unique ou une gaine intérieure qui est disposée de manière amovible dans une gaine extérieure d'une enveloppe.

17. Adaptateur d'essai selon l'une des revendications précédentes, caractérisé par le fait que la longueur d'au moins une partie des tiges de contact, et de préférence de la plupart de ces tiges de contact (11; 11') ou de toutes, est nettement supérieure à l'épaisseur de la platine composée avant (16) ou, respectivement, de la platine composée avant (16) ou de la platine composée arrière (17).

18. Adaptateur d'essai selon la revendication 17, caractérisé par le fait la longueur de la tige de contact (11; 11') s'élève à au moins 3 fois l'épaisseur de la platine composée avant (16), et de préférence à au moins 4 fois cette épaisseur.

19. Adaptateur d'essai selon l'une des revendications précédentes, caractérisé par le fait qu'au moins une partie des tiges de contact (11; 11'), et de préférence la plupart de ces tiges de contact ou toutes, font saillie des deux côtés de la platine composée avant (16).

**Claims**

1. A testing adapter for a testing device for the electrical testing of electrical, preferably electronic testpieces (18) such as electrical or electronic circuitries and circuits, printed circuit boards or fixed wirings, for freedom from electrical faults, which testing adapter (10) has a planar thick front combined plate (16) having a multiplicity of through-holes which are penetrated by electrically conductive contact pins, preferably spring contact pins, which pins are electrically insulated from each other in the testing adapter and whose outer diameter is preferably maximum 1.4 mm in the region of the through-holes of the front combined plate and which each have a contact tip (23) axially movable against restoring forces, preferably against spring action, in the direction towards the front combined plate (16), characterised in that the contact pins (11, 11') are arranged in the testing adapter (10) in such a way as to be detachable without dismantling the adapter; in that the through-holes (29, 40) of the front combined plate (16) for these contact pins (11, 11') each consist of a longitudinal portion (29) whose diameter is approximately the same as the outer diameter of the contact pin in the region located in this hole portion for radially and/or axially positioning the region of the contact pin located in the through-hole, and each consist of a remaining longitudinal portion (40) whose length and diameter are greater than the length and diameter of the other longitudinal portion (29); in that the front combined plate (16) is composed of two separate planar discs (12, 13) which rest against each other and one of which is a positioning disc (12) for the contact pins which serves in their area for radially and/or axially positioning and for axially supporting the contact pins (11, 11') and which has the longitudinal portions of smaller diameter of the through-holes of the front combined plate; and in that the other disc of the front combined plate (16) is a rigid supporting plate (13) for the positioning disc (12) resting against it, which supporting plate has the remaining longitudinal portions (40) with the larger diameter of the through-holes of the front combined plate which are penetrated by the relevant contact pins (11, 11') without being touched.

2. A testing adapter according to Claim 1, characterised in that the testing adapter (10, 10') has, at a distance from the front combined plate (16), a planar rearward combined plate (17, 17') which is parallel to the said front combined plate and which serves for rearward radial and/or axial positioning of the contact pins (11, 11') and/or to support them axially, and/or which carries connection contacts (26, 26'') for the electrical connection of the contact pins.

3. A testing adapter according to Claim 2, characterised in that the rearward combined plate (17) has through-bores which each have a longitudinal portion for radially and/or axially positioning the contact pin and a remaining longitudinal portion whose length and diameter are greater than the length and diameter of the other longitudinal portion, the rearward combined plate (17) being composed of two planar separate discs (14, 15), one of which is a positioning disc (14) for the contact pins (11) and the other disc (15) is a rigid supporting plate (15) for this positioning disc (14) resting against this positioning disc (14), this positioning disc (14) having through-bores whose diameter is approximately the same as the diameter of regions of the contact pins which are located therein, and which are those longitudinal portions of the through-bores of the rearward combined plate (17) which serve for radial and/or axial positioning of the contact pins; and in that the rearward supporting plate preferably carries connection contacts (26) for the electrical connection of the contact pins (11).

4. A testing adapter according to any one of the preceding claims, characterised in that the thickness of the positioning disc (12, 14) of the front combined plate (16), or that of the front combined plate (16) and/or of the rearward combined plate (17), is substantially less than half the thickness of the front combined plate (16) or of the rearward combined plate (17), preferably 1/20 to 1/3 of the thickness of the associated supporting disc.

5. A testing adapter according to Claim 2, 3 or 4, where the rearward combined plate (17, 17') carries the connection contacts for the electrical connection of the contact pins, characterised in that the electrical connection contacts (26'') of the rearward combined plate (17') serve to centre the rearward connection ends (22') of the contact pins (11'), which ends engage in the connection contacts and are in electrical contact therewith.

6. A testing adapter according to any one of the preceding claims, characterised in that at least a partial quantity of the contact pins (11, 11'), preferably most of or all such contact pins, have housings (19) or guide sleeves which are detachably arranged in the smaller-diameter longitudinal portions (29) of the associated through-holes (29, 40) of the front combined plate (16).

7. A testing adapter according to Claim 6, characterised in that the housings or guide sleeves of the contact pins are detachably held with frictional connection, or guided with slight slide-bearing play, in the smaller-diameter longitudinal portions (29) of the associated through-holes (29, 40) of the front combined plate (16).

8. A testing adapter according to Claim 6 or 7, characterised in that the housing (19) or the guide sleeve of the contact pin (11, 11') has an annular shoulder (20) which serves or may serve for axially supporting the housing (19) or the guide sleeve on the front combined plate (16), preferably on its positioning disc (12).

9. A testing adapter according to any one of the preceding claims, characterised in that the positioning disc (12) of the front combined plate (16) is arranged adjacent the contact tips (23) of the contact pins (11, 11').

10. A testing adapter according to any one of the preceding claims, characterised in that the positioning disc (12) and the supporting plate (13) of the front combined plate (16) are held together only outside those regions thereof which serve to accommodate the contact pins (11, 11').

11. A testing adapter according to any one of Claims 6 to 10, characterised in that at least a partial quantity of the contact pins, preferably most of or all such contact pins, are detachably held spring contact pins (11, 11'), each individual spring contact pin having a piston (21) which is firmly joined to its respective contact tip (23) and which is axially movably guided in the straight housing (19) of this spring contact pin and axially spring-loadable or spring-loaded by a spring (24) arranged in the housing and preferably supported against the housing.

12. A testing adapter according to Claim 11, characterised in that the spring contact pin (11') has, at the end region of the housing (19) facing away from the piston (21) carrying the contact tip (23), a further piston (21') which is axially slidably mounted in the housing and is spring-loaded or spring-loadable by the same spring (24) as the other piston (21) and on which a connection member (22'), serving for the electrical connection of the spring contact pin, is arranged, which member (22') is preferably rod-shaped.

13. A testing adapter according to any one of the preceding claims, characterised in that the length of that longitudinal portion (29) of the through-bore of the front combined plate, or of the through-bore of the front combined plate and/or of the through-bore of the rearward combined plate, the diameter of which portion is approximately the same as the outer diameter of the region of the contact pin located therein, is approximately 0.1 to 5 mm.

14. A testing adapter according to any one of the preceding claims, characterised in that the positioning disc (12, 14) of the front combined plate, or of the front combined plate and/or of the rearward combined plate, is a plate, a sheet or a foil.

15. A testing adapter according to any one of the preceding claims, characterised in that at least a partial quantity of the contact pins (11, 11'), preferably most of or all such contact pins, are constructed in each case as a needle or as a wire which is slidably guided in the smaller-diameter longitudinal section of the relevant through-hole (29) of the front combined plate.

16. A testing adapter according to any one of the preceding claims, characterised in that the contact pins or a partial quantity thereof each have a single jacket or an inner jacket which is detachably arranged in an outer jacket of a housing.

17. A testing adapter according to any one of the preceding claims, characterised in that the length of at least a partial quantity of the contact pins, preferably of most of or all such contact pins (11, 11'), is substantially greater than the thickness of the front combined plate (16), or of the front combined plate (16) or of the rearward combined plate (17).

18. A testing adapter according to Claim 17, characterised in that the length of the contact pin (11, 11') is at least three times, preferably at least 4 times, the thickness of the front combined plate (16).

19. A testing adapter according to any one of the preceding claims, characterised in that at least a partial quantity of the contact pins (11, 11'), preferably most of or all such contact pins, project beyond the front combined plate (16) on both sides.

FIG.1

FIG.2

*FIG.3*